# EUROPEAN PATENT SPECIFICATION

(11) **EP 1 628 514 B1**
(45) Date of publication and mention of the grant of the patent: **11.05.2011**
(21) Application number: 05016792.3
(22) Date of filing: 02.08.2005
(51) Int. Cl.: H02M 7/00, H05K 7/20, H05K 7/14

(54) **Heat radiating structure for electronic equipment**
Wärmeabstrahlstruktur für eine elektronische Anlage
Heat radiating structure d'un équipement électrique

(30) Priority: 09.08.2004 JP 2004232651
(43) Date of publication of application: 22.02.2006
(73) Proprietor: OMRON CORPORATION, Kyoto-shi, Kyoto 600-8530 (JP)
(72) Inventor: Ogawa, Tadahiko, c/o Omron Corporation, Shimogyo-ku Kyoto-shi, Kyoto 600-8530 (JP); Oka, Seiji, c/o Omron Corporation, Shimogyo-ku Kyoto-shi, Kyoto 600-8530 (JP)
(74) Representative: Kilian, Helmut

(56) References cited:
- EP-A- 0 455 969
- EP-A1- 0 103 412
- EP-A2- 0 356 991
- DE-U1- 20 016 013

## Description

### BACKGROUND OF THE INVENTION

### Technical Field

The invention relates to a heat radiating structure for electronic equipment, in which a heat generating part is housed inside of a casing.

### Background Art

In, for example, electronic equipment including a heat generating part such as a power source device housed inside of a casing in the prior art, a temperature inside of the casing has become higher when heat generated at the heat generating part stays inside of the casing, thereby raising a problem such as degradation of performance or breakage of other electronic parts housed inside of the casing.

In view of this, the prior art has taken countermeasures such that an increase in temperature inside of the casing is prevented by radiating the heat generated at the heat generating part.

Alternatively, there has been conventionally known a method for effectively radiating heat generated at a heat generating part, in which a heat sink having numerous fins is fixed to the heat generating part, to thus enlarge a heat radiating area, thereby enhancing a heat radiating effect at the heat generating part, as disclosed in, for example, Japanese Patent Application Laid-open (JP-A) No. 11-233980.

Otherwise, electronic equipment such as a solar inverter of outdoor specifications, which is installed outdoors for use, includes many heat generating parts housed inside of a casing. Therefore, a heat radiating effect cannot be sufficiently produced only by fixing a heat sink to the heat generating part.

In view of this, a cooling fan has been disposed independently of the heat sink in the prior art, to allow outside air to flow inside of the casing, thereby further enhancing the heat radiating effect by the heat sink.

However, the heat sink in the prior art has been constituted of a flat plate made of metal having a high heat conductivity such as aluminum and numerous fins projecting from one surface of the flat plate. Only both surfaces of the flat plate and both surfaces of each of the fins have served as heat radiating surfaces. The tip of each of the fins has not functioned as a heat radiating surface.

As a consequence, in the case where the heat sink is used for radiating the heat in the electronic equipment such as the solar inverter using the many heat generating parts, the heat radiating area need be enlarged by increasing the size of the heat sink, thereby raising a problem that the electronic equipment cannot be reduced in size.

In addition, a dustproof/waterproof structure has been required for the electronic equipment of the outdoor specifications, which is installed outdoors for use, in accordance with the standard of IP54, IP55 or the like. However, in the case of the electronic equipment for allowing the outside air to flow into the casing by the cooling fan disposed at a portion of the casing, so as to radiate the heat generated at the heat generating part, dust, rain water or the like may be sucked into the casing by the cooling fan, thereby raising a problem that the dustproof/waterproof structure is hardly adopted.

A heat radiating structure according to the preamble of claim 1 is known from EP-A2-0 356 991 and DE 200 16 013 U1.

### DISCLOSURE OF THE INVENTION

The invention has been accomplished to solve the above-described problems experienced in the prior art. Therefore, an object of the invention is to provide a heat radiating structure for electronic equipment, in which a heat radiating effect is excellently produced, and further, a dustproof/waterproof structure can be readily adopted.

The invention is as defined in claim 1.

A heat radiating structure for electronic equipment according to the invention including a casing containing therein electronic parts and a printed board housed inside of an electronic part containing chamber defined inside of the casing, a heat generating part and the like, and a heat sink for radiating heat generated at the heat generating part, includes: a duct of an air-tight structure formed in such a manner as to surround the periphery of the electronic part containing chamber; a suction port formed at one end of the duct, for sucking outside air into the duct; an exhaust port formed at the other end of the duct, for exhausting air from the duct; a cooling fan disposed on the way of the duct; and a heat sink housed inside of the duct, the inside of the heat sink being divided into a plurality of passages by a heat radiating fin; wherein the heat generating part is fixed at an outside surface of the heat sink.

With the above-described configuration, almost all of the outside air sucked into the duct by the cooling fan flows inside of the heat sink, to thus radiate the heat generated at the heat generating part fixed to the heat sink, thereby efficiently radiating the heat generated at the heat generating part. Furthermore, the inside of the electronic part containing chamber cannot become high in temperature caused by the heat generated at the heat generating part, thus preventing any degradation of the performance or breakage of the electronic part contained inside of the electronic part containing chamber due to the heat in advance.

The heat radiating structure for the electronic equipment according to the invention is constituted of the duct of the air-tight structure formed in such a manner as to surround the periphery of the electronic part containing chamber, so that dust, rain water or the like cannot be sucked into the electronic part containing chamber by the cooling fan, thereby providing an excellent dustproof/waterproof structure.

In the heat radiating structure for electronic equipment according to the invention, the duct of the air-tight structure is formed between both side plates and upper plate of the casing and partition walls which are formed in such a manner as to surround the right, left and upper sides of the electronic part containing chamber, and further, the suction port is formed at a lower portion of one side plate of the casing while the exhaust port is formed at a lower portion of the other side plate of the casing.

With the above-described configuration, the partition walls can inhibit the dust, rain water or the like sucked into the duct from intruding into the electronic part containing chamber, thereby readily providing the electronic equipment of a dustproof/waterproof structure in accordance with a standard. Furthermore, the heat sink or the cooling fan is separated from and positioned above the suction port or the exhaust port, so that the heat sink or the cooling fan cannot be contaminated or broken or a heat radiating effect cannot be deteriorated caused by the dust or rain water intruding through the suction port or the exhaust port.

In the heat radiating structure for electronic equipment according to the invention, the heat sink is formed into a shape of a polygonal cylinder, one side surface of the cylindrical portion of the heat sink being fixed onto a side of the casing while the heat generating part being fixed to the residual surfaces.

With the above-described configuration, all of the side surfaces except for the heat sink fixing surface serve as heat radiating surfaces, so that the heat can be radiated from a plurality of heat generating parts without any increase in size of the heat sink by fixing the heat generating parts to the heat radiating surfaces of the heat sink even in the case of the electronic equipment including the heat generating parts housed inside of a casing, thus reducing the size of the electronic equipment.

With the heat radiating structure for the electronic equipment according to the invention, almost all of the outside air sucked into the duct by the cooling fan flows through the heat sink, to thus radiate the heat generated at the heat generating part fixed to the heat sink, thereby efficiently radiating the heat generated at the heat generating part. Furthermore, no dust, rain water or the like sucked into the duct can intrude into the electronic part containing chamber, thereby readily providing the electronic equipment of the dustproof/waterproof structure in accordance with the standard.

### BRIEF DESCRIPTION OF THE DRAWINGS

Fig. 1 shows a perspective view seen from above showing electronic equipment adopting a heat radiating structure in a preferred embodiment according to the invention.
Fig. 2 shows a perspective view seen from below showing the electronic equipment adopting the heat radiating structure in the preferred embodiment according to the invention.
Fig. 3 shows a front view showing the electronic equipment adopting the heat radiating structure in a state in which a front cover is detached in the preferred embodiment according to the invention.
Fig. 4 shows a cross-sectional view taken along a line A-A of Fig. 1.
Fig. 5 shows a cross-sectional view taken along a line B-B of Fig. 1.
Fig. 6 shows an enlarged perspective view showing the vicinity of a heat sink in the heat radiating structure for the electronic equipment in the preferred embodiment according to the invention, and
Fig. 7 shows a view explanatory of function of the heat radiating structure for the electronic equipment in the preferred embodiment according to the invention.

### DESCRIPTION OF THE PREFERRED EMBODIMENTS

A description will be given below of a preferred embodiment according to the invention in reference to the attached drawings.

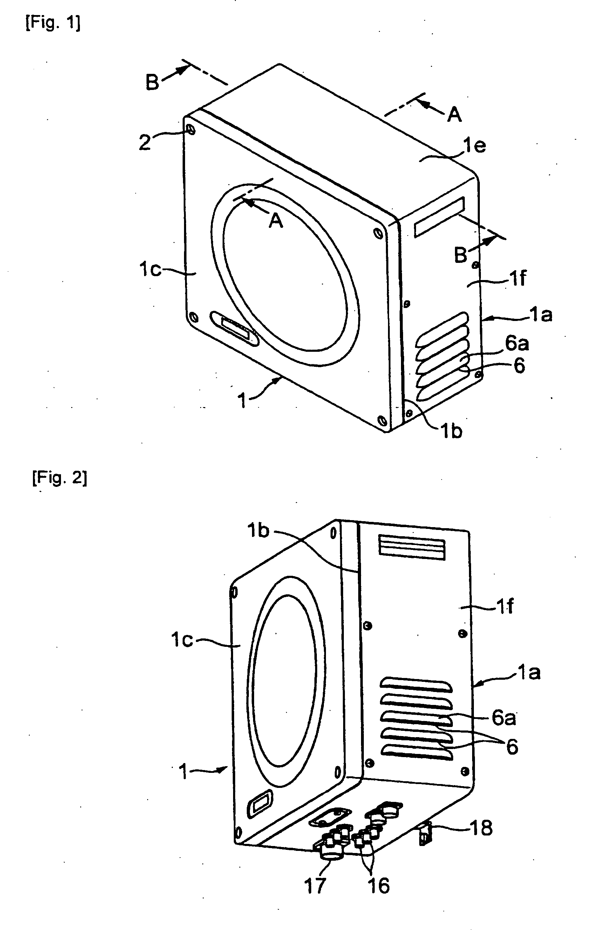

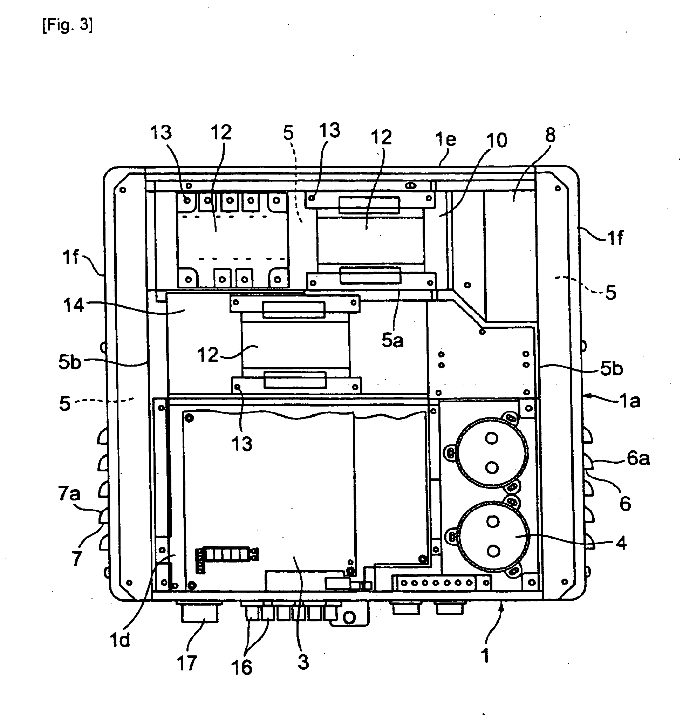

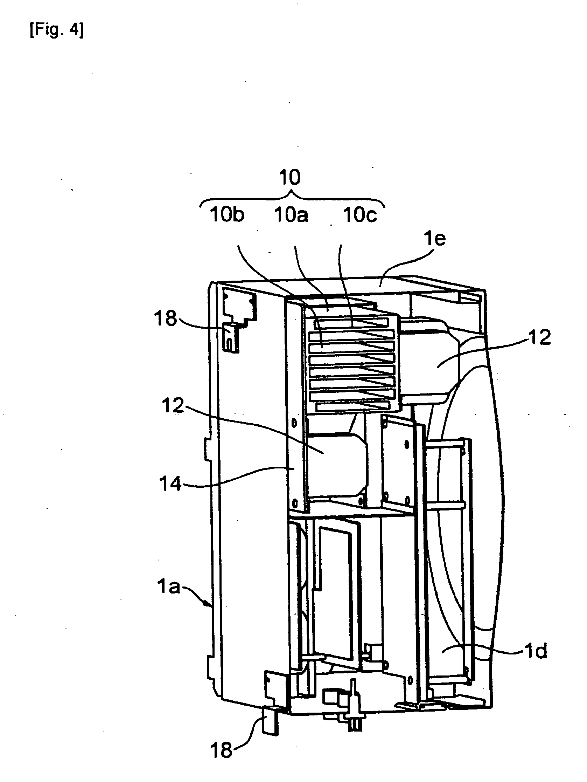

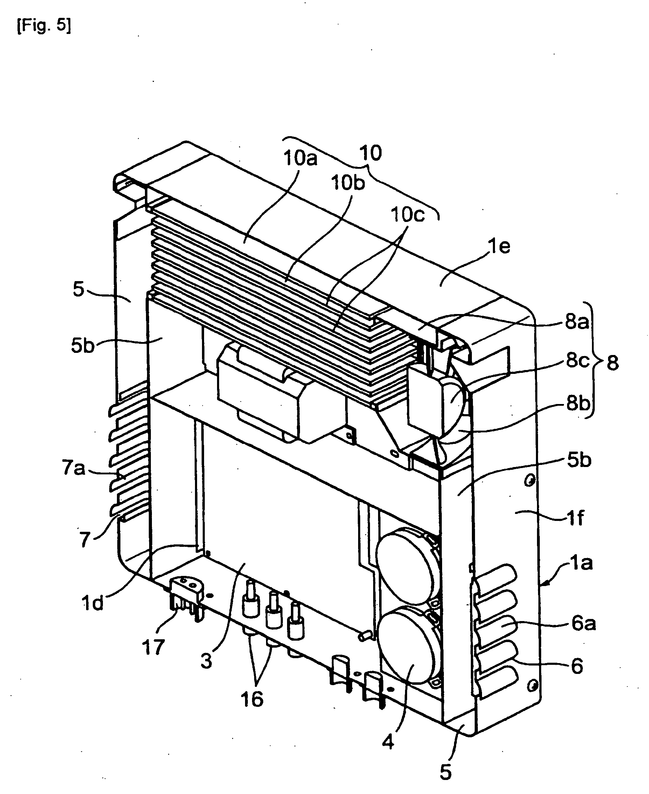

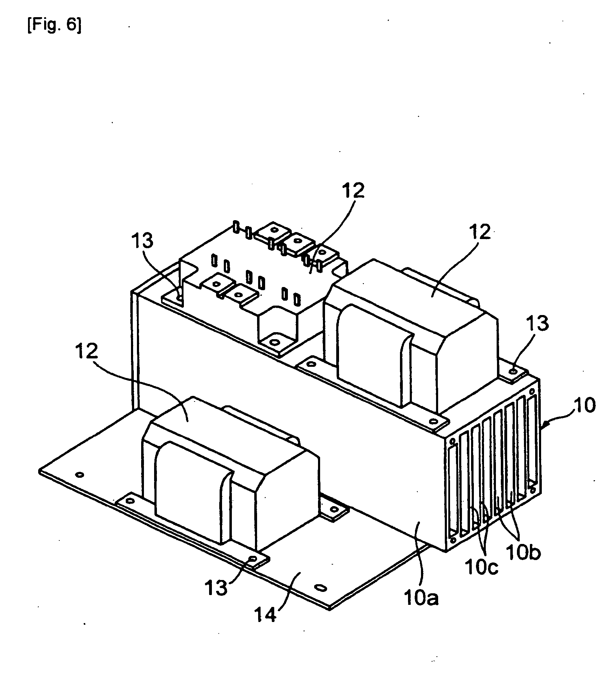

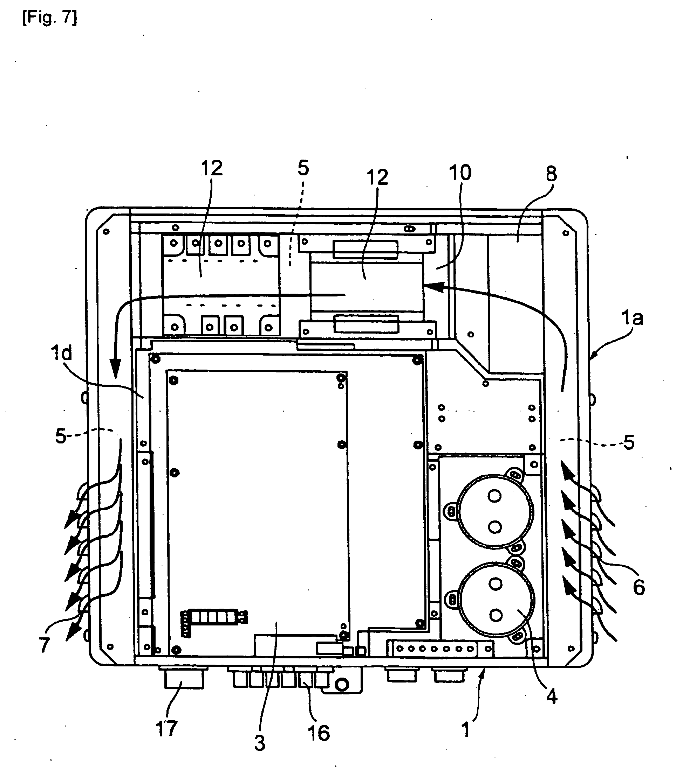

Fig. 1 is a perspective view seen from above showing electronic equipment such as a solar inverter of outdoor specifications, which is installed outdoors for use; Fig. 2 is a perspective view seen from below; Fig. 3 is a front view in a state in which a front cover is detached; Fig. 4 is a vertically perspective view taken along a line A-A of Fig. 1; Fig. 5 is a vertically perspective view taken along a line B-B of Fig. 1; Fig. 6 is a perspective view showing the vicinity of a heat sink; and Fig. 7 is a view explanatory of function.

A main body 1 of electronic equipment is flat in a lengthwise direction, and includes a casing 1a made of metal formed into a substantially square shape, as viewed from the front.

A front surface of the casing 1a is opened. To an opening 1b is detachably attached a front cover 1c. The front cover 1c is fixed at four corners thereof to the casing 1a with fixtures 2 such as screws.

An electronic part containing chamber 1d is defined inside of the casing 1a. Inside of the electronic part containing chamber 1d are contained one or a plurality of printed boards 3 mounting electronic parts thereon and other electronic parts 4.

Additionally, partition walls 5a and 5b are disposed in such a manner as to surround the upper, right and left sides of the electronic part containing chamber 1d in the casing 1a. A duct 5 of an air-tight structure is formed between the partition walls 5a and 5b and an upper plate 1e and right and left side plates 1f of the casing 1a.

One end of the duct 5 communicates with suction ports 6 opened at a lower portion of one of the side plates 1f of the casing 1a, such that outside air can be introduced into the duct 5 through the suction ports 6. A flange 6a for inhibiting any intrusion of rain water or the like into the casing 1a projects at the suction port 6. In contrast, the other end of the duct 5 communicates with exhaust ports 7 opened to a lower portion of the other side plate 1f of the casing 1a, such that air staying inside of the duct 5 can be exhausted to the outside. A flange 7a, which is similar to the flange 6a for the suction port 6, projects at the exhaust port 7.

A cooling fan 8 for sucking the outside air into the duct 5 through the suction ports 6 is disposed above the electronic part containing chamber 1d, that is, at an end on a side of the suction port at the duct 5 horizontally disposed at the upper portion inside of the casing 1a.

The cooling fan 8 is constituted of a casing 8a, a fan 8b housed inside of the casing 8a and an electric motor 8c for driving the fan 8b. On an exhaust side of the cooling fan 8 is horizontally disposed a heat sink 10 of an integral structure formed by extruding metal having a high heat conductivity such as aluminum.

The heat sink 10 includes a cylindrical portion 10a having a square cylindrical shape and heat radiating fins 10c for dividing the inside of the cylindrical portion 10a into a plurality of flat passages 10b as shown in Fig. 6. In this manner, four outer surfaces of the cylindrical portion 10a and both side surfaces of each of the heat radiating fins 10c serve as heat radiating surfaces. As a consequence, the heat radiating surface is remarkably increased in area in comparison with a heat sink having a fin projecting at one surface of a flat plate in the prior art.

Packings, not shown, are interposed at a joint between an inlet side of the heat sink 10 and the casing 8a of the cooling fan 8 and at a joint between an outlet side of the heat sink 10 and the duct 5 on the exhaust port side, thereby preventing dust, rain water or the like, which has been sucked into the duct 5, from intruding onto the side of the electronic part containing chamber 1d through the joints.

A heat generating part 12 such as an AC reactor or an insulated gate bipolar transistor (abbreviated as "an IGBT") is fixed at a front surface of the heat sink 10 via fixtures 13 such as screws. In addition, another heat generating part 12 such as a DC reactor is fixed to a heat radiating plate 14 tightly secured to a rear surface of the heat sink 10 via fixtures 13 such as screws.

Incidentally, in the drawings, reference numeral 16 designates a drawing port for drawing a cable, not shown, into the casing 1a; 17, a connector for connecting a power source or the like; and 18, a bracket for fixing the main body 1 onto an outer wall or the like of a building.

Next, explanation will be made on the function of the heat radiating structure for the electronic equipment such constituted as described above.

The main body 1 of the electronic equipment having the parts contained inside of the casing 1a is fixed onto the outer wall or the like of the building via the bracket 18, and then, is used. In using the main body 1, necessary wiring is carried out by drawing the cables into the casing 1a through the drawing ports 16 formed at the bottom surface of the casing 1a and the power source or the like is connected, thereby turning the electronic equipment into an operable state. Thereafter, the front cover 1c is attached to the front opening 1b of the casing 1a.

In this state, when the electronic equipment is started to be operated, the cooling fan 8 is rotated, and then, the outside air is sucked into the duct 5 through the suction ports 6.

The outside air sucked into the duct 5 is sent into the heat sink 10 having the square cylindrical shape disposed at the upper portion inside of the casing 1a by the cooling fan 8, as indicated by an arrow in Fig. 7.

Heat, which has been generated at the heat generating part 12 fixed to the front surface or the other heat generating part 12 fixed to the heat radiating plate 14 secured to the rear surface and has been transmitted to the heat sink 10, is efficiently radiated by the air passing through the heat sink 10.

The heat staying inside of the electronic part containing chamber 1d is radiated to the air flowing through the heat sink 10 by a surface not having any heat generating part 12, which serves as a heat radiating surface, thereby radiating not only the heat generated at the heat generating part 12 but also the heat generated inside of the electronic part containing chamber 1d.

The air passing through the heat sink 10 is exhausted from the exhaust ports 7 to the outside of the casing 1a through the duct 5 on the side of the exhaust ports 7. Hereinafter, the heat generated at the heat generating part 12 is radiated by sequentially repeating the above-described operation. Since the suction ports 6 for sucking the outside air are formed at the lower portion at either side surface of the casing 1a and the heat sink is disposed inside of the duct 5 at the upper portion of the casing 1a, the dust, rain water or the like sucked through the suction ports 6 together with the outside air seldom reaches the heat sink 10. In addition, the duct 5 has the air-tight structure, so that the dust, rain water or the like intruding into the duct 5 is prevented from intruding into the electronic part containing chamber 1d containing the electronic part 4 or the printed board 3 therein. Consequently, it is possible to readily provide electronic equipment of a dustproof/waterproof structure in accordance with the standard of IP54 or IP55.

Even in the case where one outer surface of the heat sink 10 formed into the square cylindrical shape is fixed to the casing 1a, the heat generated at the heat generating parts 12 can be radiated by fixing the heat generating parts 12 to the residual three sides. As a consequence, even in electronic equipment such as a solar inverter having many heat generating parts 12 housed inside a casing 1a, heat generated at a plurality of heat generating parts 12 can be radiated without any increase in size of the heat sink 10. Thus, the heat sink 10 never obstructs the reduction of the size of the electronic equipment.

Incidentally, although the description has been given of the wall-mounted electronic equipment, in which the main body 1 of the electronic equipment is fixed onto the wall surface of the building for use, in the above-described preferred embodiment, the invention may be applied to floor-standing electronic equipment, which is installed on a floor for use, or electronic equipment installed indoors for use.

Otherwise, although the heat sink 10 has been formed into the square cylindrical shape, it may be formed into a polygonal shape such as a pentagon or a hexagon. Alternatively, the cooling fan 8 may be disposed downstream of the heat sink 10.

With the heat radiating structure for the electronic equipment according to the invention, almost all of the outside air sucked into the duct by the cooling fan flows through the heat sink, to thus radiate the heat generated at the heat generating part fixed to the heat sink, thereby efficiently radiating the heat generated at the heat generating part. Furthermore, since no dust, rain water or the like sucked into the duct can intrude into the electronic part containing chamber, the heat radiating structure for the electronic equipment according to the invention is optimum for the heat radiating structure for the electronic equipment having the heat generating parts disposed inside of the casing.

## Claims

1. A heat radiating structure for electronic equipment including a casing (1a) containing therein electronic parts (4) and a printed board (3) housed inside of an electronic part containing chamber (1d) defined inside of the casing (1a), a heat generating part (12) and the like, and a heat sink (10) for radiating heat generated at the heat generating part (12), the heat radiating structure including:
a duct (5) of an air-tight structure formed in such a manner as to surround the periphery of the electronic part containing chamber (1d);
a suction port (6) formed at one end of the duct (5), for sucking outside air into the duct (5);
an exhaust port (7) formed at the other end of the duct (5), for exhausting air from the duct (5);
a cooling fan (8) disposed on the way of the duct (5) ; and
a heat sink (10) housed inside of the duct (5), the inside of the heat sink (10) being divided into a plurality of passages (10b) by a heat radiating fin (10c);
wherein the heat generating part (12) is fixed at an outer surface of the heat sink (10); **characterized in that**
the duct (5) of the air-tight structure is formed between both side plates and upper plate of the casing (1a) and partition walls which are formed in such a manner as to surround the right, left and upper sides of the electronic part containing chamber (1d), and further, the suction port (6) is formed at a lower portion of one side plate of the casing (1a) while the exhaust port (7) is formed at a lower portion of the other side plate of the casing (1a); and
the heat sink (10) is formed into a shape of a polygonal cylinder, one side surface of the cylindrical portion (10a) of the heat sink (10) being fixed onto a side of the casing (1a) while the heat generating part (12) being fixed to the residual surfaces.

## Patentansprüche

1. Wärmeabstrahlaufbau für ein elektronisches Gerät, welcher ein Gehäuse (1a), das elektronische Teile (4) und eine Leiterplatte (3), aufgenommen in einer elektronische Teile enthaltenden Kammer (1d), die in dem Gehäuse (1a) definiert ist, einen Wärmeerzeugsteil (12) und dergleichen enthält, und einen Kühlkörper (10) zur Abstrahlung von an dem Wärme erzeugenden Teil (12) erzeugter Wärme aufweist, wobei der Wärmeabstrahlungsaufbau enthält:
einen Kanal (5) eines luftdichten Aufbaus, der so ausgebildet ist, dass er die Außenfläche der elektronische Teile enthaltenden Kammer (1d) umgibt;
eine Ansaugöffnung (6), die an einem Ende des Kanals (5) ausgebildet ist, zum Ansaugen von Außenluft in den Kanal (5);
eine Ausströmöffnung (7), die an dem anderen Ende des Kanals (5) ausgebildet ist, zum Abführen von Luft aus dem Kanal (5);
einen Kühlventilator (8), der im Weg des Kanals (5) angeordnet ist; und
einen in dem Kanal (5) aufgenommenen Kühlkörper (10), wobei das Innere des Kühlkörpers (10) durch eine Wärme abstrahlende Rippe (10c) in eine Anzahl von Durchgängen (10b) unterteilt ist;
wobei der Wärme erzeugende Teil (12) an einer Außenfläche des Kühlkörpers (10) befestigt ist; **dadurch gekennzeichnet, dass**
der Kanal (5) des luftdichten Aufbaus zwischen beiden Seitenplatten und oberer Platte des Gehäuses (1a) sowie Trennwänden, die in einer solchen Weise ausgebildet sind, dass sie die rechte, linke und obere Seite der das elektronische Teil enthaltenden Kammer (1d) umgeben ausgebildet ist, und ferner die Ansaugöffnung (6) in einem unteren Abschnitt der einen Seitenplatte des Gehäuses (1a) ausgebildet ist, während die Ausströmöffnung (7) in einem unteren Abschnitt der anderen Seitenplatte des Gehäuses (1a) ausgebildet ist; und
der Kühlkörper (10) Form eines polygonalen Zylinders ausgebildet ist, wobei eine Seitenfläche des zylindrischen Abschnitts (10a) des Kühlkörpers (10) an einer Seite des Gehäuses (1a) befestigt ist, während der Wärme erzeugende Teil (12) an den restlichen Flächen befestigt ist.

## Revendications

1. Structure à rayonnement thermique pour équipement électro-nique comprenant un boîtier (1a) contenant des pièces électroniques (4) et un circuit imprimé (3) logé à l'intérieur d'une enceinte (1d) contenant des pièces électroniques et prévue à l'intérieur du boîtier (1a), une pièce génératrice de chaleur (12) et autres, ainsi qu'un drain thermique (10) destiné à rayonner la chaleur générée au niveau de la pièce génératrice de chaleur (12), la structure à rayonnement thermique incluant ;
• une conduite (5) d'une structure étanche à l'air cheminant de sorte qu'elle entoure la périphérie de l'enceinte (1d) contenant des pièces électroniques ;
• un orifice d'aspiration (7) formé à une extrémité de la conduite (5), pour l'aspiration d'air extérieur dans la conduite (5) ;
• un orifice de sortie (6) formé à l'autre extrémité de la conduite (5), pour l'extraction de l'air contenu dans la conduite (5) ;
• un ventilateur de refroidissement (5) placé dans le sens de la conduite (5) ; et
• un drain thermique (10) contenu dans la conduite (5), l'intérieur du puits de chaleur (10) étant divisé en plusieurs passages (10b) par une ailette à rayonnement thermique (10c) ;
• où la pièce génératrice de chaleur (12) est fixée sur une surface extérieure du drain thermique (10) ; **caractérisée en ce que**
• la conduite (5) de la structure étanche à l'air est constituée entre les deux plaques latérales et la plaque supérieure du boîtier (1a) et des cloisons de séparation qui sont formées de sorte qu'elles entourent les côtés droit, gauche et supérieur de l'enceinte (1d) contenant des pièces électroniques, et que par ailleurs l'orifice d'aspiration (6) est constitué dans une partie inférieure d'une plaque latérale du boîtier (1a) tandis que l'orifice de sortie (7) est constitué dans une partie inférieure de l'autre plaque latérale du boîtier (1a) ; et
• que le drain thermique (10) est configuré sous forme de cylindre polygonal, une surface latérale de la partie cylindrique (10a) du drain thermique (10) étant fixée sur un côté du boîtier (1a) tandis que la pièce génératrice de chaleur (12) est fixée sur les autres surfaces.
